# FASCICULE DE BREVET EUROPEEN

(11) **EP 1 738 199 B1**
(45) Date de publication et mention de la délivrance du brevet: **16.01.2008**
(21) Numéro de dépôt: 05746943.9
(22) Date de dépôt: 12.04.2005
(51) Int. Cl.: G01T 1/202, C01F 17/00

(54) **MATERIAU SCINTILLATEUR A BASE DE TERRE RARE A BRUIT DE FOND NUCLEAIRE REDUIT**
SCINTILLATORMATERIAL AUF DER BASIS VON SELTENERDE MIT VERRINGERTEM KERNHINTERGRUND
SCINTILLATOR MATERIAL BASED ON RARE EARTH WITH A REDUCED NUCLEAR BACKGROUND

(30) Priorité: 14.04.2004 FR 0403897
(43) Date de publication de la demande: 03.01.2007
(73) Titulaire: Saint-Gobain Cristaux & Detecteurs, 92400 Courbevoie (FR)
(72) Inventeur: ILTIS, Alain, 77690 MONTIGNY SUR LOING (FR)
(74) Mandataire: Colombier, Christian
(86) Numéro de dépôt international: PCT/FR2005/050231
(87) Numéro de publication internationale: WO 2005/103760

(56) Documents cités:
- WO-A-01/60944
- BARBER W C ET AL: "Scintillator energy and flux linearity for RbGd2Br7:Ce, LaCl3;Ce, and LaBr3:Ce" 10 novembre 2002 (2002-11-10), 2002 IEEE NUCLEAR SCIENCE SYMPOSIUM CONFERENCE RECORD. / 2002 IEEE NUCLEAR SCIENCE SYMPOSIUM AND MEDICAL IMAGING CONFERENCE. NORFOLK, VA, NOV. 10 - 16, 2002, IEEE NUCLEAR SCIENCE SYMPOSIUM CONFERENCE RECORD, NEW YORK, NY : IEEE, US, PAGE(S) 936-938 , XP010663678 ISBN: 0-7803-7636-6 le document en entier
- SHAH K S ET AL: "LaBr3:Ce scintillators for gamma ray spectroscopy" 2002 IEEE NUCLEAR SCIENCE SYMPOSIUM CONFERENCE RECORD. / 2002 IEEE NUCLEAR SCIENCE SYMPOSIUM AND MEDICAL IMAGING CONFERENCE. NORFOLK, VA, NOV. 10 - 16, 2002, IEEE NUCLEAR SCIENCE SYMPOSIUM CONFERENCE RECORD, NEW YORK, NY : IEEE, US, vol. VOL. 3 OF 3, 10 novembre 2002 (2002-11-10), pages 92-95, XP010663491 ISBN: 0-7803-7636-6
- VAN LOEF E V D ET AL: "Scintillation properties of LaCl3:Ce<3+> crystals: fast, efficient and high-energy-resolution scintillators" NUCLEAR SCIENCE SYMPOSIUM CONFERENCE RECORD, 2000 IEEE LYON, FRANCE 15-20 OCT. 2000, PISCATAWAY, NJ, USA,IEEE, US, 15 octobre 2000 (2000-10-15), pages 6-31, XP010556505 ISBN: 0-7803-6503-8

## Description

La présente invention concerne un matériau scintillateur à bruit de fond nucléaire réduit, généralement du type cristal scintillateur et son utilisation, notamment dans des détecteurs pour rayons gamma et/ou rayons X.

Les cristaux scintillateurs sont largement utilisés dans des détecteurs pour rayons gamma, rayons X, rayons cosmiques et particules dont l'énergie est de l'ordre de 1 KeV et également supérieure à cette valeur.

Un cristal scintillateur est un cristal transparent dans le domaine de longueur d'onde de scintillation, qui répond à une radiation incidente par l'émission d'une impulsion lumineuse.

A partir de tels cristaux, généralement sous forme de monocristaux, on peut fabriquer des détecteurs où la lumière émise par le cristal que comprend le détecteur, est couplée à un moyen de détection de la lumière et produit un signal électrique proportionnel au nombre d'impulsions lumineuses reçus et à leur intensité. De tels détecteurs sont utilisés notamment dans l'industrie pour des mesures d'épaisseur ou de grammage, dans les domaines de la médecine nucléaire, de la physique, de la chimie, de la recherche pétrolière, la détection de matières dangereuses ou illicites.

De nouveaux cristaux scintillants à base d'halogénures de terre rare ont été mis au point récemment. Il s'agit par exemple de chlorure de lanthane dopés Ce (LaCl₃ :Ce), de Bromure de Lanthane dopés Ce (LaBr₃ :Ce) de K₂Lal₅ dopé Ce. On peut décrire ces nouveaux composés sous la formule:

AₙLnₚXₙ₊₃ₚ

ou A est un élément alcalin ou un mélange d'éléments alcalins tel que Li, Na, K, Cs, Rb, de préférence Li, Na, Cs ; Ln est une ou un mélange de terres rares de valence 3+, en particulier Sc, Y, La, Gd, Lu et X est un ou plusieurs halogène, tel que CI, Br, I, ces compositions pouvant par ailleurs être dopées par Ce ou Pr (voir par example "Scintillator energy and flux linearity for RbGd2BR7 Ce, LaCl3:Ce,LaBr3:Ce '',Barber W.C. et al·,10.11.2002, IEEE Nuclear Science Symposium,New York). Ces nouveaux matériaux présentent des caractéristiques désirables pour des applications en scintillation telles que : densité et pouvoir d'arrêt supérieur au Nal :Tl, temps de décroissance de la scintillation rapide , et bonne résolution en énergie. Cependant, un problème limite leur intérêt dans les applications de spectroscopie Gamma : ces matériaux présentent un bruit de fond nucléaire à haute énergie due à la présence en leur sein d'émetteurs alpha. La présence d'atomes radioactifs à l'état de traces dans la matière induit en effet la présence de raies qui masquent les raies gamma que l'on cherche à détecter. Les applications gênées par le bruit de fond nucléaire sont par exemple les détecteurs pour la radio-protection, la prospection pétrolière et pour la recherche de traces de matières radioactive dans l'environnement.

Le cas de bruit de fond nucléaire le mieux étudié dans la famille des halogénures de lanthanides est celui de LaCl₃:10%Ce (Comparison of LaCl₃:Ce and Nal :Tl scintillators in gamma-ray spectrometry / Marcin Balcerzyk ; Marek Moszynski ; Maciej Kapusta. Nuclear Instruments & Radiation Measurements ; Section A). Rappelons que par LaCl₃:10%Ce , l'homme du métier désigne habituellement un chlorure de La et de Ce dans lequel le nombre de mole de Ce représente 10% du nombre de mole total de Ce + La. On dit également que le taux molaire de substitution de La par Ce est 10%. Dans le cas de ce cristal, on observe des pics d'émissions dus à des désintégration d'émetteurs alpha de la famille de L'uranium 235 et en particulier ²²⁷Th, ²²³Ra, ²¹⁹Rn, ²¹⁵Po, et le ²¹⁴Po de la chaîne de l'uranium 238. Bien qu'en quantités moindres, on observe également des éléments provenant de la chaîne de désintégration du Thorium 232. Le rendement de l'émission lumineuse généré par un rayonnement alpha d'énergie donnée varie de matériau à matériau. Ce rendement d'émission est traditionnellement exprimé en comparant le rendement d'émission dûe à une particule alpha au rendement dû à un rayon gamma. Dans le cas du LaCl₃, ce rendement est de alpha/gamma = 0,33+/- 0,01. Dans le cas du LaBr₃, ce rendement est de alpha/gamma = 0,29+/- 0,01. Dans le cas du LaCl₃, le rayonnement alpha émis par la désintégration du ²¹⁴Po à 7,7 MeV apparaît donc dans le spectre comme le ferait une raie gamma d'énergie 2,5 MeV (pour le LaBr₃, il apparaît pour une énergie de 2,23 MeV). Or, quand on fait de la spectroscopie gamma c'est justement ce type de raies qu'on essaie de détecter.

On comprend donc bien que la présence de ce bruit de fond nucléaire gêne l'utilisation d'un scintillateur comme LaCl₃. Ces raies sont d'autant plus faciles à détecter que la masse de scintillateur mis en oeuvre est importante et qu'on réalise un comptage de longue durée dans la zone correspondant à des rayons gamma d'énergie 1-3 MeV. C'est pourquoi ce phénomène ne peut être détecté que sur des échantillons de taille suffisante (quelques grammes ne suffisent pas).

L'objet de l'invention est donc un procédé permettant de réduire d'un facteur au moins 10 ce bruit de fond nucléaire, correspondant à des rayonnements alpha d'énergie comprise entre 4 et 8 MeV. Ce rayonnement provenant de la désintégration de l'uranium et de ses éléments fils, on pourrait penser que la solution est assez simple : il suffirait de doser l'uranium dans les matières premières et de trouver des matières premières qui soient exemptes de traces d'Uranium.

Pour un cristal de LaCl₃ présentant un taux de comptage de 0,89 coups/cc/s soit 0,89 Bq/cc, la quantité d'Uranium correspondant à cette contamination est de 1,4 ppm, ce qui est aisément détectable en GD-MS. Cependant, l'analyse de ce même cristal en GD-MS montre un taux d'uranium < 0,005 ppm. La pollution du cristal ne vient donc pas de l'Uranium lui-même, mais des éléments qui sont issus de la désintégration de ce dernier tels que ²¹⁴Po. Ces derniers sont présents en des quantités au moins un milliardième de fois plus faible que U et Th et sont donc indétectables dans le cristal. Dans l'écorce terrestre, les concentrations des 13 éléments qui composent la chaîne de désintégration de l'uranium 235 dont ²²⁷Th, ²²³Ra, ²¹⁹Rn , ²¹⁵Po sont en équilibre séculaire c'est à dire que dans une durée donnée, on a le même nombre de désintégrations de chacun de ces éléments. L'analyse GD-MS prouve donc que nous ne sommes pas dans le cas des cristaux de LaCl₃ dans des conditions d'équilibre séculaire. Lors de la fabrication des matières premières, on a enlevé l'Uranium, mais pas tous les autres éléments de la chaîne. En particulier le Radium et l'Actinium ont un comportement chimique très voisin de celui des terres rares et restent donc dans la solution de terre rare lors de l'élimination de l'uranium et du thorium. Toute la difficulté du problème réside donc dans le fait d'enlever un polluant dont il est très difficile de détecter la présence.

Nous avons donc analysé les matières premières qui nous servent à fabriquer les cristaux avec un détecteur de type puits en germanium. Malheureusement, le rayonnement alpha est peu pénétrant. Il est arrêté par la poudre par exemple de sel de terres rares avant d'arriver au détecteur de radiations. Les raies alpha que l'on cherche (i.e celles entre 4 et 8 MeV) sont donc inobservables. L'interprétation des spectres de rayonnement gamma est ambiguë.

D'une manière surprenante la demanderesse a constaté que l'intensité du rayonnement émis par une matière première entre 30 et 120 KeV permettait d'identifier les matières riches en éléments fils de l'uranium, ce que les techniques analytiques plus classiques (c'est-à-dire la GD-MS qui vient de « Glow discharge mass spectroscopy ») ne permettent pas. Par ailleurs, il est apparu que l'essentiel de la radioactivité était concentrée dans les seuls sels de terres rares, et en particulier dans celles de fort rayon ionique et de valence III (en particulier les sels de lanthane). Il est apparu en outre que la teneur en éléments fils de l'Uranium variait de manière très importante d'un fournisseur de terres rares à l'autre sans doute selon les minerais et les mines d'où étaient issus les sels de terres rares et selon également le procédé utilisé pour séparer les sels de terres rares entre eux. La teneur en radioactivité semble être particulièrement faible dans les sels de terres rares issus des minerais ioniques de chine du sud, assez élevée dans les minerais de basnaesite de Chine du Nord et très élevée dans la monazite d'australie.

Ainsi, l'invention concerne un matériau scintillateur, généralement du type monocristal, comprenant un halogénure de terre rare essentiellement du type chlorure, bromure, iodure, ou fluorure, généralement de formule AₙLnₚX₍₃ₚ₊ₙ₎ dans laquelle Ln représente une ou plusieurs terre rare(s), X représente un ou plusieur(s) atome(s) d'halogène choisi parmi F, CI, Br ou I, et A représente un ou plusieurs alcalin(s) comme K, Li, Na, Rb ou Cs, n et p représentant des valeurs telles que
- n, pouvant être nul, est inférieur où égal à 2p ,
- p est supérieur ou égal à 1.

Les terres rares (sous forme d'halogénures) concernées sont celles de la colonne 3 (selon la nouvelle notation comme mentionné dans le Handbook of Chemistry and Physics 1994-1995, 75^{ème} édition) du tableau périodique des éléments, incluant Sc, Y, La, et les Lanthanides de Ce à Lu. Sont plus particulièrement concernés les halogénures de Y, La, Gd et Lu, notamment dopés au Ce ou Pr (le terme « dopant » se référant ici à une terre rare généralement minoritaire en mole, se substituant à une ou plusieurs terres rares généralement majoritaires en mole, les minoritaires et majoritaires étant compris sous le sigle Ln).

Notamment, sont plus particulièrement concernés les matériaux de formule AₙLnₚ₋ₓLn'ₓX₍₃ₚ₊ₙ₎ dans laquelle A, X, n et p ont la signification précédemment donnée, Ln étant choisi parmi Y, La, Gd, Lu ou un mélange de ces éléments, Ln' étant un dopant tel que Ce ou Pr, et x est supérieur ou égal à 0,01 et inférieur à 1, et va plus généralement de 0,01 à 0,9. On s'intéresse dans le cadre de l'invention notamment aux matériaux combinant les caractéristiques suivantes :
- A choisi parmi Li, Na et Cs,
- Ln choisi parmi Y, La, Gd, Lu ou un mélange de ces terres rares, Ln étant plus particulièrement La,
- Ln' étant Ce,
- X choisi parmi F, CI, Br, I ou un mélange de plusieurs de ces halogènes, notamment un mélange de CI et Br, ou un mélange de Br et I.

Le matériau scintillateur inorganique selon l'invention a une teneur en éléments fils de l'Uranium et du Thorium suffisamment faible pour que l'activité issue du rayonnement alpha de ces éléments soit inférieure à 0,7 Bq/cc (il peut donc comprendre ces éléments fils de l'Uranium et du Thorium, mais en suffisamment faible quantité). Les sels de terres rares utilisés pour sa synthèse peuvent avoir subi un procédé de purification destiné à en extraire les éléments fils de l'uranium et du Thorium. Il est généralement sous forme de monocristal. Le monocristal peut-être de grande dimension, c'est-à-dire d'au moins 1 cm³, voire d'au moins 10 cm³ et même d'au moins 200 cm³. Ce monocristal peut ensuite être découpé aux tailles adaptées aux applications souhaitées.

Le matériau selon l'invention est particulièrement adapté comme scintillateur d'un détecteur utilisé notamment dans l'industrie pour des mesures d'épaisseur ou de grammage, dans les domaines de la médecine nucléaire, de la physique, de la chimie, de la recherche pétrolière. Du fait de sa sensibilité, il est particulièrement adapté à la recherche de traces de matière radioactive, par exemple en radio-protection et en recherche de matières dangereuses ou illicites.

La sélection des fournisseurs dans les exemples suivants a été faite de la manière suivante :
On a pris 120 g de poudre de La₂O₃ de différents fournisseurs (attention, il faut toujours comparer entre eux les même composés chimiques). On a compté pendant 16h l'émission X dans la gamme 30-130 KeV. Les résultats étaient les suivants :

| | |
|---|---|
| Fournisseur A | 640 584 cps |
| Fournisseur B | 525 578 cps |
| Fournisseur C | 496 912 cps. |

Une partie importante des coups mesurés provient de l'environnement du détecteur Germanium, mais cette activité est constante entre ces trois mesures. On s'intéresse donc à la différence entre les spectres.

Puis, on a utilisé ces même lots d'oxyde de lanthane pour produire des halogénures de Lanthane anhydres.

### Exemple 1 (comparatif):

A partir d'oxyde de lanthane du fournisseur A extrait de la monazite australienne et fourni par Rhodia, on synthétise 10 kg de LaCl₃ anhydre. La teneur en Uranium de ce sel est < 0,005 ppm telle que mesurée par GD-MS.
Ce LaCl₃ anhydre est fondu. On obtient des cristaux selon les méthodes de croissance classiques telle que Bridgman ou Czochralski. On fabrique ensuite un détecteur cylindrique de 12 mm par 12mm dont on mesure ensuite le bruit de fond en chambre de plomb dans une gamme d'énergie correspondant à des rayons gamma de 1,5 à 2,5 MeV, c'est à dire à des rayons alpha de 5 à 8 MeV. Le bruit de fond mesuré correspond à une activité de 14 Bq/cc.

### Exemple 2 (comparatif):

A partir d'oxyde de lanthane du fournisseur A extrait de la monazite australienne et fourni par Rhodia, on synthétise 10 kg de LaBr₃ anhydre. La teneur en Uranium de ce sel est < 0.005 ppm telle que mesurée par GD-MS. Ce LaBr₃ anhydre est fondu. On obtient des cristaux selon les méthodes de croissance classiques telle que Bridgman ou Czochralski. On mesure ensuite le bruit de fond de ces cristaux dans une gamme d'énergie correspondant à des gammas de 1,45 à 2,3 MeV, c'est à dire à des rayons alpha de 5 à 8 MeV. Le bruit de fond mesuré correspond à une activité de 14 Bq/cc.

### Exemple 3 :

A partir d'oxyde de lanthane du fournisseur B extrait des minerais argileux de chine du sud on synthétise 10 kg de LaCl₃ anhydre. La teneur en Uranium de ce sel est < 0,005 ppm telle que mesurée par GD-MS.
Ce LaCl₃ anhydre est fondu. On obtient des cristaux selon les méthodes de croissance classiques telle que Bridgman ou Czochralski. On mesure ensuite le bruit de fond de ces cristaux dans une gamme d'énergie correspondant à des gammas de 1,5 à 2,5 MeV, c'est à dire à des rayons alpha de 5 à 8 MeV. Le bruit de fond mesuré correspond à une activité de 0,02 Bq/cc.

### Exemple 4:

A partir d'oxyde de lanthane du fournisseur B extrait des minerais argileux de chine du sud, on synthétise 10kg de LaCl₃ anhydre et 10kg de LaBr₃ anhydre. La teneur en Uranium de ce sel est < 0,005 ppm telle que mesurée par GD-MS.
On mélange ensuite 10g de ce LaCl₃ avec 90g de LaBr₃ pour obtenir la composition La(Cl_{0,1}, Br_{0,9})₃. On obtient des cristaux selon les méthodes de croissance classiques telle que Bridgman. On mesure ensuite le bruit de fond de ces cristaux dans une gamme d'énergie correspondant à des gammas de 1,45 à 2,3 MeV, c'est à dire à des alphas de 5 à 8 MeV. Le bruit de fond mesuré correspond à une activité de 0,02 Bq/cc.

### Exemple 5 :

A partir d'oxyde de lanthane du fournisseur C extrait des minerais argileux de chine du sud, on synthétise 10 kg de LaCl₃ anhydre. La teneur en Uranium de ce sel est < 0,005 ppm telle que mesurée par GD-MS.
Ce LaCl₃ anhydre est fondu. On obtient des cristaux selon les méthodes de croissance classiques telle que Bridgman ou Czochralski. On mesure ensuite le bruit de fond de ces cristaux dans une gamme d'énergie correspondant à des gammas de 1,5 à 2,5 MeV, c'est à dire à des alphas de 5 à 8 MeV. Le bruit de fond mesuré correspond à une activité de 0,03 Bq/cc.

### Exemple 6 :

A partir d'oxyde de lanthane du fournisseur C extrait des minerais argileux de chine du sud, on synthétise 10 kg de la composition suivante La(Cl_{0,99} Br_{0,01})3 anhydre. La teneur en Uranium de ce sel est < 0,005 ppm telle que mesurée par GD-MS.
Ce LaCl3 anhydre est fondu. On obtient des cristaux selon les méthodes de croissance classiques telle que Bridgman ou Czochralski. On mesure ensuite le bruit de fond de ces cristaux dans une gamme d'énergie correspondant à des gammas de 1,5 à 2,5 MeV, c'est à dire à des alphas de 5 à 8 MeV. Le bruit de fond mesuré correspond à une activité de 0,03 Bq/cc.

### Exemple 7:

A partir d'oxyde de lanthane du fournisseur B extrait des minerais argileux de chine du sud, on synthétise 1 kg de K₂Lal₅ anhydre sur la base du procédé décrit dans la demande WO2004/050792. La teneur en Uranium de ce sel est < 0,005 ppm telle que mesurée par GD-MS.
On mélange ensuite 100g de ce K₂Lal₅ avec 5g de Cel₃. On obtient des cristaux selon les méthodes de croissance classiques telle que Bridgman. On mesure ensuite le bruit de fond de ces cristaux dans une gamme d'énergie correspondant à des alphas de 5 à 8 MeV. Le bruit de fond mesuré correspond à une activité de 0,02 Bq/cc. Le pic du potassium à 1,4 MeV dans ce composé est bien défini. Il est beaucoup moins gênant dans l'application que le massif complexe due à l'activité alpha de la chaîne de L'uranium et du Thorium

### Exemple 8 :

A partir d'oxyde de lanthane du fournisseur B extrait des minerais argileux de chine du sud on synthétise 10 kg de LaF₃ anhydre. La teneur en Uranium de ce sel est < 0,005 ppm telle que mesurée par GD-MS.
Ce LaF₃ anhydre est fondu. On obtient des cristaux selon les méthodes de croissance classiques telle que Bridgman ou Czochralski. On mesure ensuite le bruit de fond de ces cristaux dans une gamme d'énergie correspondant à des rayons alpha de 5 à 8 MeV. Le bruit de fond mesuré correspond à une activité de 0,02 Bq/cc.

## Revendications

1. Matériau scintillateur inorganique de formule AₙLₙₚX₍₃ₚ₊ₙ₎ dans laquelle Ln représente une ou plusieurs terre rare(s), X représente un ou plusieur(s) atome(s) d'halogène choisi parmi F, CI, Br ou I, et A représente un ou plusieurs alcalin(s) comme K, Li, Na, Rb ou Cs, n et p représentant des valeurs telles que n, pouvant être nul, est inférieur où égal à 2p , et que p est supérieur ou égal à 1, **caractérisé en ce que** sa teneur en éléments fils de l'Uranium et du Thorium est suffisamment faible pour que l'activité issue du rayonnement alpha de ces éléments soit inférieure à 0,7 Bq/cc.

2. Matériau selon la revendication précédente, **caractérisé en ce qu'**il est de formule AₙLnₚ₋ₓLn'ₓX₍₃ₚ₊ₙ₎ dans laquelle Ln est choisi parmi Y, La, Gd, Lu ou un mélange de ces éléments, Ln' est choisi parmi Ce ou Pr, et x est supérieur ou égal à 0,01 et inférieur à 1.

3. Matériau selon la revendication précédente, **caractérisé en ce que** x va de 0,01 à 0,9.

4. Matériau selon l'une des deux revendications précédentes **caractérisé en ce que** Ln est La et Ln' est Ce.

5. Matériau selon l'une des revendications précédentes, **caractérisé en ce que** n est nul.

6. Matériau selon l'une des revendications précédentes **caractérisé en ce que** X est un mélange de Cl et Br.

7. Matériau selon l'une des revendications 1 à 5 **caractérisé en ce que** X est un mélange de Br et I.

8. Matériau selon l'une des revendications précédentes **caractérisé en ce qu'**il est sous forme de monocristal.

9. Matériau selon la revendication précédente, **caractérisé en ce qu'**il a un volume d'au moins 10 cm³.

10. Matériau selon la revendication précédente, **caractérisé en ce qu'**il a un volume d'au moins 200 cm³.

11. Matériau selon l'une des revendications précédentes **caractérisé en ce que** les sels de terres rares utilisés pour sa synthèse proviennent des minerais ioniques de Chine du sud.

12. Matériau selon l'une des revendications précédentes **caractérisé en ce que** les sels de terres rares utilisés pour sa synthèse ont subi un procédé de purification destiné à en extraire les éléments fils de l'uranium et du Thorium.

13. Matériau selon l'une des revendications 1 à 11 **caractérisé en ce qu'**il comprend des éléments fils de l'Uranium et du Thorium.

14. Procédé de préparation d'un matériau de l'une des revendications précédentes faisant intervenir comme matière première source de Ln un oxyde de Ln comprenant des éléments fils de l'Uranium et du Thorium en suffisamment faible quantité pour que le matériau présente une activité issue du rayonnement alpha de ces éléments inférieure à 0,7 Bq/cc.

15. Détecteur comprenant un matériau scintillateur de l'une des revendications précédentes.

16. Utilisation du détecteur de la revendication précédente pour des mesures d'épaisseur ou de grammage, ou dans les domaines de la médecine nucléaire, de la physique, de la chimie, de la recherche pétrolière, la recherche de traces de matière radioactive en radio-protection ou la recherche de matières dangereuses ou illicites.

## Claims

1. An inorganic scintillator material of formula AₙLnₚX₍₃ₚ₊ₙ₎ in which Ln represents one or more rare earths, X represents one or more halogen atoms, chosen from F, Cl, Br or I, and A represents one or more alkali metals, such as K, Li, Na, Rb or Cs, n and p representing values such that n, which may be zero, is less than or equal to 2p, and that p is greater than or equal to 1, **characterized in that** its content of daughter elements of uranium and thorium is low enough for the activity resulting from the alpha radiation from these elements to be less than 0.7 Bq/cc.

2. The material as claimed in the preceding claim, **characterized in that** it has the formula AₙLnₚ₋ₓLn'ₓX₍₃ₚ₊ₙ₎ in which Ln is chosen from Y, La, Gd, Lu or a mixture of these elements, Ln' is chosen from Ce and Pr, and x is greater than or equal to 0.01 but less than 1.

3. The material as claimed in the preceding claim, **characterized in that** x ranges from 0.01 to 0.9.

4. The material as claimed in either of the two preceding claims, **characterized in that** Ln is La and Ln' is Ce.

5. The material as claimed in one of the preceding claims, **characterized in that** n is zero.

6. The material as claimed in one of the preceding claims, **characterized in that** X is a mixture of Cl and Br.

7. The material as claimed in one of claims 1 to 5, **characterized in that** X is a mixture of Br and I.

8. The material as claimed in one of the preceding claims, **characterized in that** it is in the form of a single crystal.

9. The material as claimed in the preceding claim, **characterized in that** it has a volume of at least 10 cm³.

10. The material as claimed in the preceding claim, **characterized in that** it has a volume of at least 200 cm³.

11. The material as claimed in one of the preceding claims, **characterized in that** the rare-earth salts used to synthesize it come from ionic South China ores.

12. The material as claimed in one of the preceding claims, **characterized in that** the rare-earth salts used to synthesize it have undergone a purification process intended to extract the daughter elements of uranium and thorium therefrom.

13. The material as claimed in one of claims 1 to 11, **characterized in that** it includes daughter elements of uranium and thorium.

14. A process for preparing a material as claimed in one of the preceding claims, involving as Ln source raw material, an Ln oxide, which includes daughter elements of uranium of thorium in a sufficiently low quantity for the material to have an activity resulting from the alpha radiation from these elements of less than 0.7 Bq/cc.

15. A detector comprising a scintillator material as claimed in one of the preceding claims.

16. The use of the detector as claimed in the preceding claim for coating weight or thickness measurements, or in the fields of nuclear medicine, physics, chemistry and oil exploration, in the search for traces of radioactive material in radioprotection or in the search for dangerous or illicit materials.

## Patentansprüche

1. Anorganisches Szintillatormaterial mit der Formel AₙLnₚX₍₃ₚ₊ₙ₎, in welcher Ln ein oder mehrere Seltenerdmetalle, X ein oder mehrere aus F, Cl, Br oder I ausgewählte Halogenatome und A ein oder mehrere Alkalimetalle wie K, Li, Na, Rb oder Cs bedeutet und n und p derartige Werte bedeuten, dass n, das gleich Null sein kann, kleiner als oder gleich 2p und p größer als oder gleich 1 ist, **dadurch gekennzeichnet, dass** sein Gehalt an Tochterelementen des Urans und Thoriums genügend niedrig ist, damit die aus der α-Strahlung dieser Elemente stammende Aktivität kleiner als 0,7 Bq/cm³ ist.

2. Material nach dem vorhergehenden Anspruch, **dadurch gekennzeichnet, dass** es die Formel AₙLnₚ₋ₓLn'ₓX₍₃ₚ₊ₙ₎ hat, in welcher Ln aus Y, La, Gd, Lu oder einem Gemisch dieser Elemente und Ln' aus Ce oder Pr ausgewählt ist und x größer als oder gleich 0,01 und kleiner als 1 ist.

3. Material nach dem vorhergehenden Anspruch, **dadurch gekennzeichnet, dass** x 0,01 bis 0,9 beträgt.

4. Material nach einem der zwei vorhergehenden Ansprüche, **dadurch gekennzeichnet, dass** Ln La und Ln' Ce ist.

5. Material nach einem der vorhergehenden Ansprüche, **dadurch gekennzeichnet, dass** n Null ist.

6. Material nach einem der vorhergehenden Ansprüche, **dadurch gekennzeichnet, dass** X ein Gemisch aus Cl und Br ist.

7. Material nach einem der Ansprüche 1 bis 5, **dadurch gekennzeichnet, dass** X ein Gemisch aus Br und I ist.

8. Material nach einem der vorhergehenden Ansprüche, **dadurch gekennzeichnet, dass** es in Form eines Einkristalls vorliegt.

9. Material nach dem vorhergehenden Anspruch, **dadurch gekennzeichnet, dass** sein Volumen mindestens 10 cm³ beträgt.

10. Material nach dem vorhergehenden Anspruch, **dadurch gekennzeichnet, dass** sein Volumen mindestens 200 cm³ beträgt.

11. Material nach einem der vorhergehenden Ansprüche, **dadurch gekennzeichnet, dass** die für seine Synthese verwendeten Seltenerdmetallsalze aus ionischen Erzen aus Südchina stammen.

12. Material nach einem der vorhergehenden Ansprüche, **dadurch gekennzeichnet, dass** die für seine Synthese verwendeten Seltenerdmetallsalze einem Reinigungsverfahren unterworfen wurden, das vorgesehen ist, daraus die Tochterelemente des Urans und Thoriums zu extrahieren.

13. Material nach einem der Ansprüche 1 bis 11, **dadurch gekennzeichnet, dass** es Tochterelemente des Urans und Thoriums enthält.

14. Verfahren zur Herstellung eines Materials nach einem der vorhergehenden Ansprüche, an welchem als Ausgangsstoff für Ln ein Ln-Oxid beteiligt ist, das Tochterelemente des Urans und Thoriums in einer ausreichend kleinen Menge enthält, damit das Material eine aus der α-Strahlung dieser Elemente stammende Aktivität, die geringer als 0,7 Bq/cm³ ist, aufweist.

15. Detektor, der ein Szintillatormaterial nach einem der vorhergehenden Ansprüche umfasst.

16. Verwendung des Detektors nach dem vorhergehenden Anspruch zu der Messung von Dicke bzw. Flächengewicht oder auf den Gebieten der Nuklearmedizin, Physik, Chemie und Erdölerkundung und der Suche nach Spuren radioaktiver Materie beim Strahlenschutz oder der Suche nach gefährlichen oder verbotenen Stoffen.
